# EUROPÄISCHE PATENTSCHRIFT

(11) **EP 1 222 715 B1**
(45) Veröffentlichungstag und Bekanntmachung des Hinweises auf die Patenterteilung: **05.02.2003**
(21) Anmeldenummer: 00992960.5
(22) Anmeldetag: 03.11.2000
(51) Int. Cl.: H01R 12/32, H01R 43/02

(54) **VERBINDUNGSVORRICHTUNG ZUM AUFLÖTEN AUF PLATINEN FÜR DEN ANSCHLUSS VON ELEKTRISCHEN LEITERN, VERFAHREN ZUR HERSTELLUNG DER VERBINDUNGSVORRICHTUNG SOWIE VORRICHTUNG ZUM ANSCHLUSS EINES LEITERS AN DER VERBINDUNGSVORRICHTUNG**
CONNECTING DEVICE TO BE SOLDERED TO CIRCUIT BOARDS FOR CONNECTION OF ELECTRICAL CONDUCTORS, A METHOD FOR PRODUCTION OF THE CONNECTING DEVICE AND A DEVICE FOR CONNECTING CONDUCTORS TO THE CONNECTING DEVICE
DISPOSITIF DE CONNEXION PERMETTANT LE BRASAGE SUR DES PLATINES POUR LE RACCORD DE CONDUCTEURS ELECTRIQUES, SON PROCEDE DE FABRICATION ET DISPOSITIF PERMETTANT DE RACCORDER UN CONDUCTEUR AUDIT DISPOSITIF DE CONNEXION

(30) Priorität: 05.11.1999 DE 19953362; 03.04.2000 DE 10016565
(43) Veröffentlichungstag der Anmeldung: 17.07.2002
(73) Patentinhaber: Feistkorn, Vera, 96187 Stadelhofen (DE); Wolf, Klaus, 96187 Stadelhofen (DE)
(72) Erfinder: Feistkorn, Vera, 96187 Stadelhofen (DE); Wolf, Klaus, 96187 Stadelhofen (DE)
(74) Vertreter: Schwarzensteiner, Marie-Luise, Dr.
(86) Internationale Anmeldenummer: EP0010834
(87) Internationale Veröffentlichungsnummer: WO01033673

(56) Entgegenhaltungen:
- DE-A- 3 424 387
- PATENT ABSTRACTS OF JAPAN vol. 1999, no. 10, 31. August 1999 (1999-08-31) & JP 11 135911 A (YAZAKI CORP), 21. Mai 1999 (1999-05-21)
- PATENT ABSTRACTS OF JAPAN vol. 014, no. 002 (E-868), 8. Januar 1990 (1990-01-08) & JP 01 251565 A (KYOSHIN KOGYO KK;OTHERS: 01), 6. Oktober 1989 (1989-10-06)

## Beschreibung

Die Erfindung betrifft eine Verbindungsvorrichtung zum Auflöten auf Platinen für den Anschluss eines elektrischen Leiters gemäß dem Oberbegriff des Anspruches 1. Sie betrifft auch Verfahren zur Herstellung der Verbindungsvorrichtung sowie eine Vorrichtung zum Anschluss eines Leiters an diese Verbindungsvorrichtung.

JP-A- 11135911 offenbart eine Vorrichtung nach dem Oberbegriff des Anspruchs 1.

Bei elektrischen und elektronischen Geräten ergibt sich oft die Notwendigkeit, Einzelleiter oder Flachbandleiter mit Leiterbahnen einer Leiterplatte zu verbinden. Dabei soll die dafür verwendete Vorrichtung einfach und montagefreundlich sein sowie einen sichereren Kontakt, - auch unter mechanischer Belastung -, über die Laufzeit des Gerätes gewährleisten.

Es ist die Aufgabe der Erfindung, eine Verbindungsvorrichtung zu schaffen, die neben den oben genannten Vorteilen sehr platzsparend auf starre und flexible Leiterbahnen gelötet werden kann, einfach herzustellen ist, kein Abisolieren des Leiters erforderlich macht und für die automatisierte Bestückung der Leiterplatte und automatisierte Kontaktierung der Leiter geeignet ist.

Diese Aufgabe wird mit den Merkmalen des Anspruches 1 gelöst. Die Quaderform ermöglicht die automatisierte Bestückung, z B. in SMD-Technik -, und führt zu einer geringen Baubreite der Verbindungsvorrichtung, die so mit geringem Abstand auf der Leiterplatte angeordnet werden kann. Der Leiter wird mit der Isolierung in die Nut gedrückt und kann jederzeit gelöst und erneut angeschlossen werden. Die Kanten der Nut schneiden die Isolation des Leiters ein, so dass eine Kontaktierung erfolgt.

Vorteilhafte Ausführungsformen der erfindungsgemäßen Vorrichtung ergeben sich aus den Unteransprüchen 2 bis 5. So kann durch die Vervielfachung der Nutschneiden nach dem Anspruch 2 die Kontaktsicherheit und die mechanische Festigkeit verbessert werden. Die Führungsrinne für den Leiter nach dem Anspruch 3 begünstigt die Montage. Durch die Maßnahme nach dem Anspruch 4 können einzelne Verbindungsvorrichtungen noch enger nebeneinander angeordnet werden, da im Bereich der Vertiefungen die Isolation des Leiters erhalten bleibt. Das Merkmal des Anspruches 5 verbessert die mechanische Festigkeit sowohl statisch, z. B. bei Schrägzug, als auch dynamisch bei Vibrationen.

Ein wesentliches Merkmal der Verbindungsvorrichtung nach den Ansprüchen 1 bis 5 ist aber ihre spezielle einfache Bauform, da erst durch diese Bauform mehrere sehr vorteilhafte Herstellungsverfahren für eine Massenfertigung ermöglicht werden.

Gemäß den Verfahren nach den Ansprüchen 6 und 7 können schnell und wirtschaftlich kleine und mittlere Stückzahlen gefertigt werden. Die Verfahren nach den Ansprüchen 8 bis 10 ermöglichen auf einfache Weise große Stückzahlen. Die automatische Kontaktierung kann vorteilhaft mit einer Vorrichtung erfolgen, wie sie in den Ansprüchen 11 und 12 gekennzeichnet ist.

Im folgenden wird zur Erläuterung der Erfindung eine bevorzugte Ausführungsform anhand der Zeichnungen beschrieben. Es zeigen:
- Fig. 1:: eine Ansicht der Verbindungsvorrichtung von oben
- Fig. 2:: eine Ansicht der Verbindungsvorrichtung von vorne
- Fig. 3:: eine Isometrie der Verbindungsvorrichtung

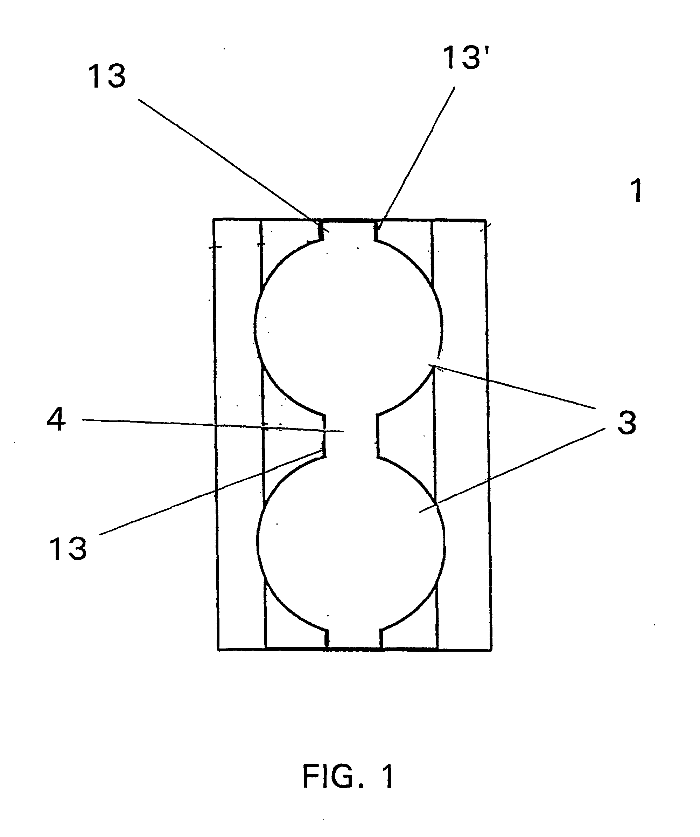

Die Fig. 1 bis 3 zeigen die erfindungsgemäße Vorrichtung in stark vergrößerter Form. Gemäß Fig. 1, welche die Verbindungsvorrichtung von oben zeigt, ist sie im Wesentlichen aus einem quaderförmigen Element 1 gebildet. Darin ist, vorzugsweise mittig, eine längsverlaufende Nut 4 ausgebildet. Fig. 1 zeigt auch zwei in dem Quader 1 über der Nut 4 ausgebildete Vertiefungen 3, die in der dargestellten Ausführungsform kreiszylinderförmig vorgesehen sind. Die Vertiefungen 3 können jedoch jeden Querschnitt aufweisen, in den eine Stempel zum Eindrükken eines Leiters einführbar ist.

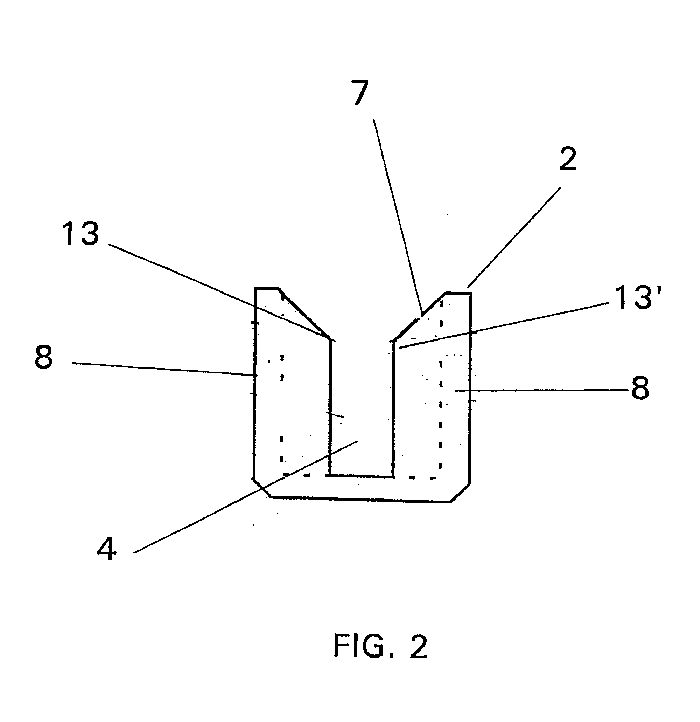

Wie sich aus Fig. 2 ergibt, wird der Quader 1 so durch Seitenwände 8 gebildet, welche die Längsnut 4 flankieren. Die Längsnut 4 muss keine Parallelnut sein, sonder kann über ihre Höhe eine veränderliche Breite aufweisen. An bzw. in der Oberfläche 2 sind im vorliegenden Ausführungsbeispiel, wie gesagt, die zwei Vertiefungen 3 vorgesehene, die so angebracht sind, dass von der Längsnut 4 nur noch drei Bereiche verbleiben. Die drei Bereiche können auch unterschiedliche Nutbreiten aufweisen. Diese drei Bereiche bilden die Nutkanten bzw. Nutschneiden, die zum Einschneiden bzw. teilweisen Abisolieren des Leiters 5 erforderlich sind.

An der Oberseite 2 ist weiterhin in Richtung der Längsnut 4 eine Führungsrinne 7 vorgesehen. Diese Führungsrinne 7 ist durch einfach Abschrägung der oberen Nutkanten ausgebildet.

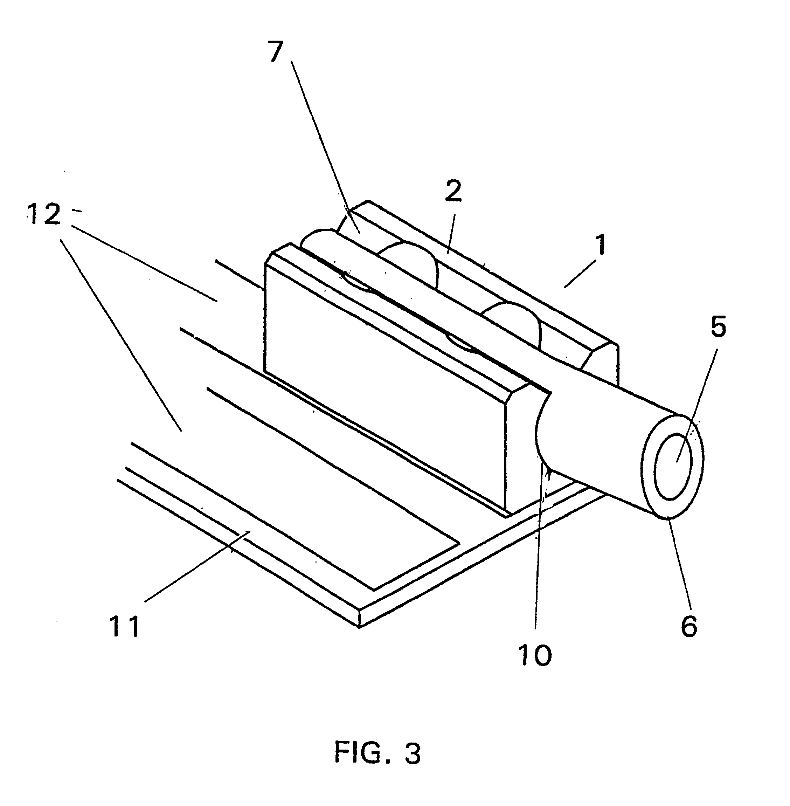

Der Quader 1 besteht aus leitendem Material, vorzugsweise leitendem Sintermaterial, und kann so unmittelbar maschinell oder von Hand auf eine Leiterbahn 12 einer Platine 11 aufgelötet werden. Zum Anschließen eines Leiters 5 wird dieser in die Führungsrinne 7 eingelegt und durch einen Stempel, der zwei an die Vertiefungen 3 angepasste Stifte aufweist, in die Längsnut 4 gedrückt. Dabei wird die Isolation 6 des Leiters 5 in den drei verbliebenen Bereichen, den Nutschneiden 13, 13', der Längsnut 4 eingeschnitten und weggedrückt, so dass in diesen Bereichen der Kontakt hergestellt wird. Diesen Zustand zeigt insbesondere Fig. 3. Hier ist auch gezeigt, dass der Bereich der Längsnut 4, an dem der Leiter 5 austritt, eine abgerundete Erweiterung 10 aufweist, dessen Vorteile oben bereits erwähnt wurden.

Die in den Fig. 1 bis 3 dargestellte Form der Vertiefungen 3 als Kreiszylinder ist wie gesagt nicht notwendig. Bei der Herstellung durch Walzen oder Prägen kann eine konische Form mit gegebenenfalls anderem Querschnitt geeigneter sein. Da der Leiter 5 nach dem Kontaktieren im Bereich der Vertiefungen 3 noch völlig isoliert ist, kann der Quader 1 zur platzsparenden Anordnung so schmal gemacht werden, dass die Vertiefungen 3 die Seitenwände durchbrechen.

Die Erfindung ist nicht auf die dargestellte Verbindungsvorrichtung beschränkt. Denkbar ist es z. B. auch Quader 1 vorzusehen, die zwei oder mehr Längsnuten parallel nebeneinander und beabstandet zueinander aufweisen. Auch können mehr als zwei Vertiefungen 3 vorgesehen sein.

Zum Anschließen des bzw. der Leiter 5 an die Verbindungsvorrichtung wird diese zusammen mit der Platine 11, welche die Leiterbahn 12 aufweist, in eine Vorrichtung gemäß der Ansprüche 11 und 12 eingebracht. Diese Vorrichtung weist eine Aufnahme für die Platine und ein dazu beweglich angeordnetes Gegenstück, - einen Stempel - auf. Die Aufnahme weist eine Aussparung mit dem Querschnitt des Quaders 1 auf. An dem Stempel sind Stifte vorgesehen, die bei der Bewegung des Stempels in die Vertiefung ragen und so einen eingelegten Leiter 5 in die Längsnut 4 der Verbindungsvorrichtung drücken. In vorteilhafter Weise ist die Aufnahme als Rinne ausgebildet, in der die Quader 1 quer oder längs dem Stempel zugeführt werden.

## Patentansprüche

1. Verbindungsvorrichtung zum Auflöten auf Platinen für den Anschluss eines elektrischen Leiters, bestehend aus einem Quader aus leitendem Material, **dadurch gekennzeichnet**, das der Quader (1) auf seiner Oberseite (2) wenigstens eine Vertiefung (3) und eine mit der (den) Vertiefung (en) verbundene Längsnut (4) aufweist, in die der Leiter (5) eindrückbar ist, wobei zur Kontaktherstellung eine Isolation (6) des Leiters (5) beim Eindrücken in die Längsnut (4) durch die Nutkanten (13, 13') einschneidbar ist.

2. Verbindungsvorrichtung nach Anspruch 1, **dadurch gekennzeichnet, dass** der Quader (1) auf der Oberseite (2) zwei oder mehrere Vertiefungen (3) in Reihe aufweist.

3. Verbindungsvorrichtung nach Anspruch 1 oder 2, **dadurch gekennzeichnet, dass** auf der Oberseite (2) des Quaders (1) eine in Richtung der Längsnut (4) verlaufende Führungsrinne (7) für den Leiter (5) vorgesehen ist.

4. Verbindungsvorrichtung nach einem der Ansprüche 1 bis 3, **dadurch gekennzeichnet, dass** die Vertiefung (3) seitlich die Wände (8) des Quaders (1) durchbricht.

5. Verbindungsvorrichtung nach einem der Ansprüche 1 bis 4, **dadurch gekennzeichnet, dass** der Bereich der Längsnut (4), an dem der Leiter (5) austritt, eine abgerundete Erweiterung (10) aufweist.

6. Verfahren zum Herstellen einer Verbindungsvorrichtung nach einem der Ansprüche 1 bis 5, **dadurch gekennzeichnet, dass** die Vertiefung(en) (3) in den Quader (1) gefräst oder gebohrt wird (werden) und die Längsnut (4) mit einem Scheibenfräser gefräst wird.

7. Verfahren nach Anspruch 6, **dadurch gekennzeichnet, dass** das Ausgangsmaterial eine Draht ist, bei dem schon beim Drahtziehen die Längsnut (4) und gegebenenfalls die Führungsrinne (7) erzeugt wird, wobei anschließend die Vertiefungen (3) durch Bohren und/oder Fräsen erzeugt werden.

8. Verfahren zum Herstellen einer Verbindungsvorrichtung nach einem der Ansprüche 1 bis 5, **dadurch gekennzeichnet, dass** aus Drahtmaterial mit rechteckigem Querschnitt mittels einer Formwalze, - nacheinander oder in einem Arbeitsschritt -, die Längsnut (4), die Vertiefungen (3) und gegebenenfalls die Führungsrinne (7) erzeugt werden und anschließend die Quader (1) abgelängt werden.

9. Verfahren nach Anspruch 8, **dadurch gekennzeichnet, dass** das Drahtmaterial schon in U-Form mit einer für den Walzvorgang geeigneten Breite der Längsnut (4) zugeführt wird.

10. Verfahren zum Herstellen einer Verbindungsvorrichtung nach einem der Ansprüche 1 bis 5, **dadurch gekennzeichnet, dass** die Quader (1) aus leitendem Sintermaterial gepresst und gesintert sind.

11. Vorrichtung zum Anschluss eines Leiters an einer Verbindungsvorrichtung nach einem der Ansprüche 1 bis 5, mit einer Aufnahme und einem beweglichen Gegenstück, **dadurch gekennzeichnet, dass** die Aufnahme eine Aussparung mit der Grundfläche des Quaders (1) aufweist und dass das Gegenstück als Stempel ausgebildet ist, der einen oder mehrere an die Vertiefung (3) bzw. die Vertiefungen (3) angepasste Stifte aufweist, die bei der Bewegung des Stempels in die Vertiefungen (3) ragen und so den eingelegten Leiter in die Längsnut (4) drücken.

12. Vorrichtung nach Anspruch 12, **dadurch gekennzeichnet, dass** die Ausnehmung in der Aufnahme als eine Rinne ausgebildet ist, in der die Quader (1) nacheinander quer oder längs dem Stempel zugeführt werden.

## Claims

1. A connector for soldering to boards for terminating an electrical conductor, consisting of a cuboid of conductive material, **characterized in that** the cuboid (1) comprises on its surface (2) at least one recess (3) and a longitudinal groove (4) connected to the recess(es) into which the conductor (5) can be urged to make the contact by the cutting edges (13, 13') of the longitudinal groove (4) thereby biting into the insulation (6) of the conductor (5).

2. The connector as set forth in claim 1, **characterized in that** the cuboid (1) comprises on its surface (2) two or more recesses (3) in a row.

3. The connector as set forth in claim 1 or 2, **characterized in that** a guide trough (7) for the conductor (5) oriented in the direction of the longitudinal groove (4) is provided on the surface (2) of the cuboid (1).

4. The connector as set forth in any of the claims 1 to 3, **characterized in that** the recess (3) penetrates the sidewalls (8) of the cuboid (1) laterally.

5. The connector as set forth in any of the claims 1 to 4, **characterized in that** the portion of the longitudinal groove (4) at which the conductor (5) emerges, comprises a rounded opening (10).

6. A method of fabricating a connector as set forth in any of the claims 1 to 5, **characterized in that** the recess(es) (3) is/are milled or drilled in the cuboid (1) and the longitudinal groove (4) is milled with a side cutter.

7. The method as set forth in claim 6, **characterized in that** the starting material is a wire, in which the longitudinal groove (4) and where necessary the guide trough (7) has already been produced on drawing the wire, the recesses (3) being subsequently produced by drilling and/or milling.

8. The method of fabricating a connector as set forth in any of the claims 1 to 5, **characterized in that** the longitudinal groove (4), the recesses (3) and where necessary the guide trough (7) are produced in sequence or in a single operation from wire material of rectangular cross-section by means of a shaping roll and the cuboids (1) subsequently cut to length.

9. The method as set forth in claim 8, **characterized in that** the wire material is supplied already in a channel section with a width of the longitudinal groove (4) suitable for the rolling operation.

10. The method of fabricating a connector as set forth in any of the claims 1 to 5, **characterized in that** the cuboid (1) are compressed and sintered from a conductive sinter material.

11. A device for terminating a conductor to a connector as set forth in any of the claims 1 to 5, including a mount and a movable counterpart, **characterized in that** the mount comprises a window having the basic surface area of the cuboid (1) and that the counterpart is configured as a driver comprising one or more pins adapted to the recesses (3) which on advancement of the driver protrude into the recess(es) (3) and thus urge the inserted conductor into the longitudinal groove (4).

12. The device as set forth in claim 12, **characterized in that** the window in the mount is configured as a trough in which the cuboids (1) can be inserted crosswise or lengthwise to the driver in sequence.

## Revendications

1. Dispositif de connexion pour le brasage sur des platines pour le raccordement d'un conducteur électrique, formé d'un parallélépipède rectangle en matériau conducteur, **caractérisé en ce que** le parallélépipède rectangle (1) présente sur sa face supérieure (2) au moins une cavité (3) et une rainure longitudinale (4) reliée à la une ou plusieurs cavités, rainures longitudinales dans laquelle le conducteur (5) peut être enfoncé, sachant que, pour établir le contact, une isolation (6) du conducteur (5) peut être entaillée par les arrêtes de rainure (13, 13'), lors du processus d'enfoncement dans la rainure longitudinale (4).

2. Dispositif de connexion selon la revendication 1, **caractérisé en ce que** le parallélépipède rectangle (1) présente en face supérieure (2) deux cavités (3), ou plus, en ligne.

3. Dispositif de connexion selon la revendication 1 ou 2, **caractérisé en ce que** sur la face supérieure (2) du parallélépipède rectangle (1) est prévue, pour le conducteur (5), une goulotte de guidage (7) s'étendant dans la direction de la rainure longitudinale (4)

4. Dispositif de connexion selon l'une des revendications 1 à 3, **caractérisé en ce que** la cavité (3) interrompt latéralement les parois (8) du parallélépipède rectangle (1).

5. Dispositif de connexion selon l'une des revendications 1 à 4, **caractérisé en ce que** la zone de la rainure longitudinale (4) sur laquelle sort le conducteur (5) présente un élargissement (10) arrondi.

6. Procédé de fabrication d'un dispositif de connexion selon l'une des revendications 1 à 5, **caractérisé en ce que** la ou les cavité(s) (3) sont ménagée(s) dans le parallélépipède rectangle (1) par un processus de fraisage ou de perçage, et la rainure longitudinale (4) est fraisée avec une fraise disque.

7. Procédé selon la revendication 6, **caractérisé en ce que** le matériau initial est un fil pour lequel, déjà lors de l'étirage du fil, la rainure longitudinale (4) et, le cas échéant, la goulotte de guidage (7) ont été façonnées, sachant que, ensuite, les cavités (3) sont produites par un perçage et/ou un fraisage.

8. Procédé de fabrication d'un dispositif de connexion selon l'une des revendications 1 à 5, **caractérisé en ce qu'**à partir du matériau en fil ayant une section transversale rectangulaire, en utilisant un rouleau de formage, on façonne - les uns après les autres, ou bien en une seule étape opératoire - la rainure longitudinale (4), les cavités (3) et, le cas échéant, la goulotte de guidage (7) et on coupe ensuite le parallélépipède rectangle (1) à longueur.

9. Procédé selon la revendication 8, **caractérisé en ce que** le matériau en fil est déjà amené sous une forme en U, avec une largeur de rainure longitudinale (4) convenant pour le processus de roulage ou laminage.

10. Procédé de fabrication d'un dispositif de connexion selon l'une des revendications 1 à 5, **caractérisé en ce que** les parallélépipèdes rectangles (1) sont façonnés par pressage de matériau fritté conducteur et sont soumis à un frittage.

11. Dispositif de raccordement d'un conducteur à un dispositif de connexion selon l'une des revendications 1 à 5, avec un logement et une pièce conjuguée mobile, **caractérisé en ce que** le logement présente un évidement avec la face de base du parallélépipède rectangle (1), et **en ce que** la pièce conjuguée est réalisée sous la forme de poinçon, présentant un ou plusieurs téton(s), adapté(s) à la cavité (3) ou aux cavités (3), tétons qui, lors du déplacement du poinçon, pénètrent dans la ou les cavité(s) et pressent le conducteur ainsi inséré dans la rainure longitudinale (4).

12. Dispositif selon la revendication 11, **caractérisé en ce que** l'évidement est réalisé dans le logement sous la forme d'une goulotte, dans laquelle les parallélépipèdes rectangles (1) sont amenés au tronçon, les uns après les autres, dans la direction transversale ou longitudinale.
